# EUROPEAN PATENT SPECIFICATION

(11) **EP 3 702 397 B1**
(45) Date of publication and mention of the grant of the patent: **09.06.2021**
(21) Application number: 19159383.9
(22) Date of filing: 26.02.2019
(51) Int. Cl.: C08G 77/60, C09D 183/16, H01L 21/02

(54) **METHOD FOR THE PREPARATION OF HYDRIDOSILANE OLIGOMERS**
VERFAHREN ZUR HERSTELLUNG VON HYDRIDOSILAN-OLIGOMEREN
PROCÉDÉ DE PRÉPARATION D'OLIGOMÈRES HYDRIDOSILANES

(43) Date of publication of application: 02.09.2020
(73) Proprietor: Evonik Operations GmbH, 45128 Essen (DE)
(72) Inventor: HOLTHAUSEN, Michael, 45721 Haltern am See (DE); ROCCARO, Maximilian, 46282 Dorsten (DE); POUGIN, Anna, 44139 Dortmund (DE); SCHMITT, Daniel, 64285 Darmstadt (DE); ZÖLLNER, Jörg, 45657 Recklinghausen (DE); DÄSCHLEIN, Christian, 44625 Herne (DE); WUNNICKE, Odo, 48161 Münster (DE)
(74) Representative: Evonik Patent Association

(56) References cited:
- US-A1- 2012 291 665

## Description

### Field of the invention

The present invention relates to a method for preparing hydridosilane oligomers and to hydridosilane oligomers obtainable by said method as well as their use. The present invention further refers to a method for preparing coating compositions and for preparing silicon-containing layers.

### Background of the invention

Hydridosilanes and their oligomers are known in literature as possible starting materials for the production of silicon layers.

Hydridosilanes are compounds that essentially only contain silicon and hydrogen atoms. Hydridosilanes known in synthetically accessible amounts have 11 or fewer silicon atoms. Hydridosilanes can in principle be gaseous, liquid or solid and -especially in the case of solids- are essentially soluble in aromatic or aliphatic solvents such as toluene or cyclooctane or in other liquid hydridosilanes such as neopentasilane (Si(SiH₃)₄). Some examples of hydridosilanes are monosilane, disilane, trisilane, cyclopentasilane and neopentasilane. Hydridosilanes with at least three or four silicon atoms can have a linear, branched or (optionally bi-/ poly-) cyclic structure with Si-H bonds and can preferably be described by the respective generic formulae SiₙH₂ₙ₊₂ (linear or branched; with n = 1 - 11) and SiₙH₂ₙ (cyclic; with n = 3 - 6) or SiₙH₂₍ₙ₋ᵢ₎ (bi- or polycyclic; n= 4-20; i= {number of cycles} -1).

Even though in principle many hydridosilanes can be used for silicon layer production, it has been shown that only higher hydridosilanes, i.e. hydridosilanes with more than 8 silicon atoms, can provide good coverage of the surface of conventional substrates and lead to homogeneous layers with few defects. Furthermore, it has been shown that only branched hydridosilanes exhibit good coating properties. Hydridosilane oligomers with high linear contents are disadvantageous as they tend to dewet in the coating process resulting in an inferior layer quality.

Many higher hydridosilanes, i.e. hydridosilanes with more than 8 silicon atoms, can be prepared by oligomerizing lower hydridosilanes.

Cyclic hydridosilanes of the formula SiₙH₂ₙ (with n = 3 - 6) are polymerized by a ring-opening mechanism. Cyclopentasilane (Si₅H₁₀) and cyclohexasilane (Si₆H₁₂) are commonly used as starting materials for the ring-opening polymerization method. The oligomerization of cyclic hydridosilanes is characterized by a loss-free conversion of hydridosilane into oligomers, but has the disadvantage that essentially only linear oligomers are formed. As described above, linear oligomers are disadvantageous for the wetting of coatings of conventional substrates, since they usually lead to non-homogeneous layers with many defects.

EP 1 640 342 A1 describes a method for the polymerization of hydridosilanes, preferably cyclopentasilanes, but also silanes of the general formula SiᵢX₂ᵢ₊₂ (with i = 2 - 10 and X = hydrogen or halogen atom). The polymerization of hydridosilanes is initiated by UV irradiation. A disadvantage of this method is the low absorption of hydridosilanes in the UV range which requires high radiation intensities for successful polymerization. Furthermore, homogeneous energy input is required which is difficult to control.

Linear and branched hydridosilanes of the formula SiₙH₂ₙ₊₂ (with n = 1 - 11) are oligomerized by polycondensation. In the case of such oligomerization of lower hydridosilanes, viewed in a formal sense, a higher hydridosilane molecule is formed from two lower hydridosilane molecules after abstraction of hydrogen and/or relatively small hydridosilyl radicals.

DE 10 2010 002 405 A1 describes methods for the polycondensation of hydridosilanes, in particular neopentasilane, which proceeds in the absence of a catalyst. DE 10 2010 041 842 A1 also refers to a method for the oligomerization of non-cyclic hydridosilanes, in particular neopentasilane. The disadvantage of these methods however is that the corresponding monomers, e.g. neopentasilane, have to be synthesized in a complex and cost-intensive way.

In addition to the previously described methods for the oligomerization of hydridosilanes, there are a number of other catalytic processes based on metal-based catalyst systems. EP 0 630 933 A2 describes a method for preparing a condensate which can be converted thermally to a semi-conductive material. The condensate is prepared via a dehydro-polymerization reaction of a hydridosilane monomer based on monomers selected from monosilane, disilane and trisilane in the presence of a catalyst comprising at least one metal and/or a metal compound. Furthermore, US 5 252 766 and WO 2008/045327 A2 relate to catalyst-supported hydridosilane syntheses, namely methods which comprise the conversion of a hydridosilane compound in the presence of a lanthanide or a transition metal complex. However, a disadvantage of these methods is that the catalysts used have to be removed in a costly and inconvenient manner after completion of the oligomerization. Moreover, the preparation of the corresponding catalyst system is costly and inconvenient.

It is thus an object of the present invention to avoid the above described disadvantages of the prior art. It is particularly desirable to minimize the use of the commonly used costly hydridosilanes such as cyclopentasilane Si₅H₁₀, cyclohexasilane Si₆H₁₂ and neopentasilane Si(SiH₃)₄ and instead use readily available and inexpensive oligomer mixtures. In addition to the processes mentioned above for the selective production of hydridosilane oligomers, several processes are known, in particular processes of industrial silicon chemistry, in which hydridosilane mixtures are produced as by-products or waste products. The advantage of such hydridosilane mixtures is that they are significantly cheaper to produce than the commonly used hydridosilanes described above. However, for formulations in coating methods based on such hydridosilane mixtures, it is detrimental that these mixtures have a high content of linear hydridosilanes and thus tend to dewet which leads to insufficient silicon-containing layers. Thus, it is in particular the object of the present invention to provide a method for preparing hydridosilane oligomers which utilizes hydridosilane mixtures with a high content of linear hydridosilanes and still provides good coating properties as well as good silicon-containing layers.

### Summary of the invention

It has now surprisingly been found that the object of the present invention is met by the method for preparing hydridosilane oligomers, comprising:
reacting a hydridosilane composition (I) comprising at least one linear hydridosilane SiₙH₂ₙ₊₂ with n ≥ 2 in the presence of a branched hydridosilane compound (II),
wherein the branched hydridosilane compound (II) comprises at least one quaternary silicon atom Si(SiR₃)₄, wherein R is chosen from the group consisting of H; SiₙH₂ₙ₊₁ with n ≥ 1; SiₘH₂ₘ with m ≥ 2; and SiⱼH₂ⱼ₋₁ with j ≥ 3.

Accordingly, the present invention relates to a hydridosilane oligomer obtainable by the method according to the present invention as well as to a use of hydridosilane oligomers obtained by the method according to the present invention.

Moreover, the present invention relates to a method for preparing a coating composition. The method for preparing a coating composition comprises (i) preparing hydridosilane oligomers according to the method for preparing hydridosilane oligomers, and (ii) diluting the hydridosilane oligomers with an organic solvent. The organic solvent is preferably an organic solvent selected from the group consisting of toluene and cyclooctane.

The present invention also refers to a method for preparing a silicon-containing layer which comprises (a) preparing hydridosilane oligomers according to the method for preparing hydridosilane oligomers; (b) optionally diluting the hydridosilane oligomers with an organic solvent; (c) applying the hydridosilane oligomer formulation on a substrate; and (d) converting the hydridosilane oligomer formulation into amorphous silicon. The organic solvent is preferably selected from the group consisting of toluene and cyclooctane.

It has surprisingly been found that the method of the present invention for preparing hydridosilane oligomers provides hydridosilane oligomers which exhibit good coating properties. Furthermore, it was surprisingly found that significantly increased layer thicknesses of amorphous silicon can be produced by using hydridosilane oligomers produced by the method of the present invention compared to layers produced directly from neopentasilane oligomers.

### Detailed description of the present invention

In the following, the present invention will be described in more detail. As used herein, the term "comprising" is understood to be open-ended and to not exclude the presence of additional undescribed or unrecited elements, materials, ingredients or method steps. The terms "including", "containing" and like terms are understood to be synonymous with "comprising". As used herein, the term "consisting of" is understood to exclude the presence of any unspecified element, ingredient or method step.

As mentioned above, the present invention relates to a method for preparing hydridosilane oligomers. The method of the present invention for preparing hydridosilane oligomers comprises reacting a hydridosilane composition (I) comprising at least one linear hydridosilane SiₙH₂ₙ₊₂ with n ≥ 2 in the presence of a branched hydridosilane compound (II). The branched hydridosilane compound (II) of the present invention comprises at least one quaternary silicon atom Si(SiR3)4, wherein R is chosen from the group consisting of H; SiₙH₂ₙ₊₁ with n ≥ 1, SiₘH₂ₘ with m ≥ 2; and SiⱼH₂ⱼ₋₁ with j ≥ 3.

According to the present invention, the hydridosilane composition (I) preferably comprises 10 to 100 wt.-% of linear hydridosilanes, more preferably 30 to 100 wt.-% of linear hydridosilanes, even more preferably 50 to 100 wt.-% of linear hydridosilanes, most preferably 70 to 100 wt.-% of linear hydridosilanes, and in particular 90 to 100 wt.-% of linear hydridosilanes, based on the total weight of the hydridosilane composition (I). Particularly, a hydridosilane composition (I) consisting of linear hydridosilanes is preferred. The hydridosilane composition (I) may further comprise iso-branched hydridosilanes. Iso-branched hydridosilanes means hydridosilanes having at least on SiH(SiR₃)₃ group, wherein R is chosen from the group consisting of H; and SiₙH₂ₙ₊₁ with n ≥ 1.

Preferably, the hydridosilane composition (I) comprises at least one linear hydridosilane SiₙH₂ₙ₊₂, wherein n is 2 to 9.

The hydridosilane composition (I) of the present invention may comprise hydridosilane mixtures having a mass average molecular weight of M_{w} in the range of 200 to 5000 g/mol, preferably 500 to 4000 g/mol and in particular 1000 to 3000 g/mol, measured by gel permeation chromatography (GPC) as described in the examples.

According to the present invention, the branched hydridosilane compound (II) preferably is selected from the group consisting of neopentasilane, neopentasilane oligomer, 2,2-disilyltetrasilane, 2,2-disilylpentasilane, 3,3-disilylpentasilane, 2,2,3-trisilyltetrasilane, 1,1-disilylcyclopentasilane, 2,2,3,3-tetrasilyltetrasilane, 2,2,3-trisilylpentasilane, 2,2,4-trisilylpentasilane, 2,2-disilylhexasilane, 3,3-disilylhexasilane, 1,1-disilylcyclohexasilane, 1,1,2-trisilylcyclopentasilane, 1,1,3-trisilylcyclopentasilane, 2,2-disilylheptasilane, 3,3-disilylheptasilane, 4,4-disilylheptasilane, 2,2,3-trisilylheptasilane, 2,2,4-trisilylheptasilane, 2,2,5-trisilylheptasilane, 2,3,3-trisilylheptasilane, 3,3,4-trisilylheptasilane, 3,3,5-trisilylheptasilane, 3-disilaneyl-3-silylhexasilane, 2,2,3,3 tetrasilylpentasilane, 2,2,3,4-tetrasilylpentasilane, 2,2,4,4-tetrasilylpentasilane, 2,3,3,4-tetrasilylpentasilane, 3-disilaneyl-2,2-disilylpentasilane, 3,3-bis(disilaneyl)pentasilane, 1,1,2-trisilylcyclohexasilane, 1,1,3-trisilylcylohexasilane, 1,1,4-trisilylcyclohexasilane, 1,1,2,2-tetrasilylcyclohexasilane, 1,1,3,3-tetrasilylcyclohexasilane, 1,1,4,4-tetrasilylcyclohexasilane, 1,1,2,3-tetrasilylcyclohexasilane, 1,1,2,4-tetrasilylcyclohexasilane, 1,1,3,4-tetrasilylcyclohexasilane and mixtures thereof. Preferably, the branched hydridosilane compound (II) can be selected from the group consisting of neopentasilane, neopentasilane oligomer, and mixtures thereof.

Herein, the neopentasilane oligomer is an oligomer of neopentasilane. Preferably, the neopentasilane oligomer has a weight average molecular weight of M_{w} in the range of 500 to 5000 g/mol, more preferably of 1000 to 4000 g/mol and in particular of 1500 to 3500 g/mol, measured by gel permeation chromatography (GPC) as described in the examples.

According to the present invention, the branched hydridosilane compound (II) may consist of neopentasilane and/or neopentasilane oligomer. Preferably, the branched hydridosilane compound (II) consists of 80 to 98 wt.-% of neopentasilane and 2 to 20 wt.-% of a neopentasilane oligomer, more preferably of 85 to 94 wt.-% of neopentasilane and 6 to 15 wt.-% of a neopentasilane oligomer, and in particular of 90 to 92 wt.-% of neopentasilane and 8 to 10 wt.-% of a neopentasilane oligomer, based on the total weight of the branched hydridosilane compound (II).

Herein, the branched hydridosilane compound (II) preferably is present in a range of 0.05 to 50 wt.-%, more preferably 0.1 to 47 wt.-%, even more preferably 1 to 45 wt.-%, most preferably 2 to 43 wt.-%, and in particular 4 to 40 wt.-%, based on the total weight of the hydridosilane composition (I) and the branched hydridosilane compound (II).

According to the present invention, the method of preparing hydridosilane oligomers can in principle be conducted as desired.

Preferably, the hydridosilane composition (I) is reacted in the presence of the branched hydridosilane compound (II) in the absence of a catalyst. Herein, the term "catalyst" refers to a substance that causes or accelerates a chemical reaction without itself being affected. Accordingly, the term "catalyst" includes, inter alia, a transition metal. The term "transition metal" refers to any element in the d-block of the periodic table, including the elements of the 3^{rd} to 12^{th} IUPAC group of the periodic table. Moreover, the term "transition metal" further refers to any element in the f-block of the periodic table, including the elements of the lanthanide and actinide series.

Furthermore, the reaction of the hydridosilane composition (I) in the presence of the branched hydridosilane compound (II) is preferably solvent-free. Alternatively, a solvent selected from the group consisting of linear, branched or cyclic, saturated, unsaturated or aromatic hydrocarbons with 1 - 12 carbon atoms, alcohols, ethers, carboxylic acids, esters, nitriles, amides, sulfoxides and water can be added to the reaction of hydridosilane composition (I) in the presence of the branched hydridosilane compound (II). Particularly preferred are n-pentane, n-hexane, n-heptane, n-octane, n-decane, dodecane, cyclohexane, cyclooctane, cyclodecane, dicyclopentane, bicyclohexyl, benzene, toluene, m-xylene, p-xylene, mesitylene, indane, indene, tetrahydronaphthalene, decahydronaphthalene, diethylether, dipropylether, ethylene glycol dimethyl ether, ethylene glycol diethyl ether, ethylene glycol methyl ether, diethylene glycol dimethyl ether, diethylene glycol diethyl ether, diethylene glycol methyl ether, tetrahydrofuran, p-dioxane, acetonitrile, dimethylformamide, dimethyl sulfoxide, dichloromethane and chloroform.

Additionally, a dopant can be added before, during or after the reaction of the hydridosilane composition (I) in the presence of the branched hydridosilane compound (II). A dopant is understood to mean an elemental polymorph or an element compound of a semimetal of the 13^{th} or 15^{th} IUPAC group of the periodic table which is capable of reacting with hydridosilanes with incorporation of at least the semimetal of the 13^{th} or 15^{th} IUPAC group of the periodic table to form a semimetal-containing oligomer. Corresponding semimetal-containing oligomers are preferentially suitable for the preparation of doped silicon layers. Suitable dopants may be selected from the group consisting of BHₓR₃₋ₓ, wherein x = 0 - 3 and R = C₁-C₁₀-alkyl radical, unsaturated cyclic, optionally ether- or amino-complexed C₂-C₁₀-alkyl radical; Si₅H₉BR₂, wherein R = H, Ph, or C₁-C₁₀-alkyl radical; Si₄H₉BR₂, wherein R = H, Ph, or C₁-C₁₀-alkyl radical; red phosphorous; white phosphorous (P₄); PHₓR₃₋ₓ, wherein x = 0 - 3 and R = Ph, SiMe₃, or C₁-C₁₀-alkyl radical; P₇(SiR₃)₃, wherein R = H, Ph, or C₁-C₁₀-alkyl radical; Si₅H₉PR₂, wherein R = H, Ph, or C₁-C₁₀-alkyl radical; and Si₄H₉PR₂, wherein R = H, Ph, or C₁-C₁₀-alkyl radical.

Preferably, the dopant(s) can be added to the reaction of the hydridosilane composition (I) in the presence of the branched hydridosilane compound (II) in proportions of 0.01 to 20 wt.-%, based on the total weight of the hydridosilane composition (I) and the branched hydridosilane compound (II).

According to the present invention, the reaction of the hydridosilane composition (I) in the presence of the branched hydridosilane compound (II) is preferably performed at a temperature in the range of 50 °C to 300 °C, more preferably 60 °C to 250 °C, even more preferably 70 °C to 200 °C, most preferably 90 °C to 180 °C and by irradiating with electromagnetic radiation, preferably in the visible spectral range. Irradiation with electromagnetic radiation is preferably carried out with a suitable light source such as a cold light lamp.

Furthermore, the present invention relates to a hydridosilane oligomer obtainable by the method for preparing hydridosilane oligomers as described above. It will be appreciated that the various components and their characteristics as well as the respective amounts described above for the method for preparing hydridosilane oligomers apply in the same manner for the hydridosilane oligomer obtainable by this method.

The hydridosilane oligomer of the present invention can have a mass average molecular weight of M_{w} in the range of 500 to 5000 g/mol, measured by gel permeation chromatography (GPC) as described in the examples. Furthermore, the hydridosilane oligomer of the present invention can have a mass average molecular weight of M_{w} in the range of 1000 to 5000 g/mol, measured by gel permeation chromatography (GPC) as described in the examples.

The hydridosilane oligomers obtainable by the method for preparing hydridosilane oligomers of the present invention are suitable for a multitude of uses. They are particularly suitable for the preparation of formulations and coating compositions as well as for preparing silicon-containing layers. Furthermore, they are particularly suitable - alone or in compositions with further constituents -for production of electronic and optoelectronic component layers. The invention thus also provides for the use of the hydridosilane oligomers obtainable by the method according to the present invention for production of optoelectronic and electronic component layers.

Accordingly, the present invention relates to a method for preparing a coating composition which comprises (i) preparing a hydridosilane oligomer according to the method for preparing hydridosilane oligomers as described above; and (ii) diluting the hydridosilane oligomer of step (i) with an organic solvent.

Suitable organic solvents according to the present invention can be selected from the group consisting of linear, branched or cyclic, saturated, unsaturated or aromatic hydrocarbons with 1 - 12 carbon atoms, alcohols, ethers, carboxylic acids, esters, nitriles, amides, sulfoxides and water. Particularly preferred are n-pentane, n-hexane, n-heptane, n-octane, n-decane, dodecane, cyclohexane, cyclooctane, cyclodecane, dicyclopentane, bicyclohexyl, benzene, toluene, m-xylene, p-xylene, mesitylene, indane, indene, tetrahydronaphthalene, decahydronaphthalene, diethylether, dipropylether, ethylene glycol dimethyl ether, ethylene glycol diethyl ether, ethylene glycol methyl ether, diethylene glycol dimethyl ether, diethylene glycol diethyl ether, diethylene glycol methyl ether, tetrahydrofuran, p-dioxane, acetonitrile, dimethylformamide, dimethyl sulfoxide, dichloromethane and chloroform. Preferably, the organic solvent of the method for preparing a coating composition is selected from the group consisting of toluene and cyclooctane.

The inventive coating composition preferably comprises 0.1 to 99 wt.-%, more preferably 10 to 97 wt.-%, most preferably 25 to 95 wt.-%, and in particular 60 to 80 wt.-% of the organic solvent, based on the total weight of the hydridosilane oligomer and the organic solvent.

The method for preparing a coating composition may further comprise adding substances such as dopants, nanoparticles or additives for adjusting the rheological properties. Suitable dopants are as described above and it will be further appreciated that other corresponding substances are known to those skilled in the art.

Moreover, the present invention relates to a method for preparing a silicon-containing layer which comprises (a) preparing a hydridosilane oligomer according to the method for preparing hydridosilane oligomers as described above; (b) optionally diluting the hydridosilane oligomer with an organic solvent; (c) applying the hydridosilane oligomer formulation on a substrate; and (d) converting the hydridosilane composition into amorphous silicon. It will be appreciated that suitable organic solvents and possible weight ranges thereof are as described above for the method for preparing of a coating composition. The hydridosilane oligomer formulation results from steps (a) and (b).

The method for preparing a silicon-containing layer may further comprise adding substances such as dopants, nanoparticles or additives for adjusting the rheological properties to the hydridosilane oligomer formulation. Suitable dopants are as described above and it will be further appreciated that other corresponding substances are known to those skilled in the art.

According to the present invention, suitable substrates for the method for preparing a silicon-containing layer can be selected from the group consisting of glass, quartz glass, graphite, metal, silicon, or of a layer of silicon, indium tin oxide, ZnO:F, ZnO:AI or SnO₂:F present on a heat-stable support. Preferred metals are aluminum, stainless steel, Cr steel, titanium, chromium or molybdenum. In addition, it is also possible to use polymer films, e.g. polyether ether ketone (PEEK), polyethylene naphthalate (PEN), polyethylene terephthalate (PET) or polyimides.

The application step (c) is preferably carried out via gas or liquid phase coating processes such as printing, spraying, aerosol assisted chemical vapor deposition, direct liquid injection chemical vapor deposition, spin-coating, dip-coating, meniscus coating, slit coating, slot-die coating and curtain coating. Suitable printing processes can be selected from the group consisting of flexographic/gravure printing, nano- or microprinting, inkjet printing, offset printing, reverse offset printing, digital offset printing and screen printing. Of the aforementioned methods, aerosol assisted chemical vapor deposition and direct liquid injection chemical vapor deposition should be included among the gas phase processes. Preference is given to application via a liquid phase coating process.

After the application of the formulation of step (c), a pre-crosslinking operation can preferably be conducted via UV irradiation of the liquid film on the substrate, after which the still-liquid film has crosslinked precursor fractions.

After application (c) and optionally pre-crosslinking of the formulation, the coated substrate may also preferably be dried prior to conversion (d), in order to remove any solvent present. Corresponding measures and conditions for this purpose are known to those skilled in the art. In order to remove exclusively volatile formulation constituents, in the case of a thermal drying operation, the heating temperature is preferably less than 200 °C.

According to the present invention, the conversion step (d) can be carried out thermally. Thermal conversion is preferably effected at temperatures of 200 to 1000 °C, more preferably 250 to 750 °C, and most preferably 300 to 700 °C. Corresponding rapid high-energy processes can be effected, for example, by the use of an IR lamp, a hotplate, an oven, a flash lamp, a plasma of suitable gas composition, an RTP system, a microwave system or an electron beam treatment (if required, in the respective preheated or warmed state). The conversion step (d) can further be carried out by using electromagnetic radiation, especially with UV light. Moreover, the conversion step (d) may be carried out by electron ion bombardment.

Typical conversion times are preferably between 0.1 ms and 360 min. The conversion time is more preferably between 0.1 ms and 10 min, especially preferably between 1 s and 120 s.

During or after the conversion step (d), the silicon-containing layer may further be enriched with hydrogen. This process is called hydrogen passivation, which eliminates defects in the material, and can be effected with reactive hydrogen by the hotwire method, with a hydrogen-containing plasma (remotely or directly; under reduced pressure or under atmospheric pressure) or by means of corona treatment or an electron beam treatment with supply of hydrogen. In addition, it is also possible to conduct the drying and/or conversion step (d) already described above in a hydrogen-enriched atmosphere, such that the material is hydrogen-rich from the outset.

The application step (c), the optional pre-crosslinking step, the optional drying step and/or the conversion step (d) can be carried out under oxidizing conditions.

The way in which oxidizing conditions can be established is known to those skilled in the art.

After the conversion step (d), the amorphous silicon layer may be crystallized by means of introduction of thermal energy, electromagnetic radiation and/or particle bombardment to produce fully or partly crystalline silicon-containing layers. Methods for this purpose are known to those skilled in the art.

The method for preparing a silicon-containing layer can be conducted simultaneously or more than once in succession with respect to a substrate (simultaneous or successive deposition, in which case the resulting films are partly or completely superposed on one another). Such a method for producing multilayer systems is preferentially suitable for production of systems formed from intrinsic (i.e. undoped) and doped layers, which are essential, for example, for the construction of solar cells. The method is more preferably suitable for production of multilayer systems for optimal passivation or avoidance of defects at the interface to the substrate, when a thin intrinsic (i.e. undoped) silicon-containing layer and then a layer having the opposite doping from the substrate are applied to the substrate. In this case, first an essentially dopant-free formulation and then a formulation having the opposite doping in relation to the substrate are therefore applied to a doped substrate. In addition, the substrate may be coated on both sides.

Furthermore, the present invention relates to the use of hydridosilane oligomers obtainable by the method for preparing hydridosilane oligomers as described above for producing optoelectronic or electronic components such as hetero-emitter solar cells, HIT (heterojunction with intrinsic thin layer) solar cells, selective emitter solar cells, back contact solar cells, field-effect transistors, thin film transistors, dielectric layers in microelectronic components, surface passivation of semiconductor materials, components containing quantum dots, barriers against diffusion of constituents from the environment through layers, and barrier layers for thermal decoupling of the upper and lower sides of layers.

Having generally described the present invention above, a further understanding can be obtained by reference to the following specific examples. These examples are provided herein for purposes of illustration only, and are not intended to limit the present invention, which is rather to be given the full scope of the appended claims including any equivalents thereof.

### Figures

Figure 1 shows an optical photograph demonstrating the layer quality of coatings prepared with the formulation of comparative example CE-1. On the right side of each glass substrate is a ruler with a mm scale.
Figure 2 shows an optical photograph demonstrating the layer quality of coatings prepared with the formulation of comparative example CE-2. On the right side of each sample is a ruler with a mm scale.
Figure 3 shows an optical photograph demonstrating the layer quality of coatings prepared with the formulation of comparative example CE-3. On the right side of each sample is a ruler with a mm scale.
Figure 4 shows an optical photograph demonstrating the layer quality of coatings prepared with the formulation of inventive example E-1. On the right side of each sample is a ruler with a mm scale.
Figure 5 shows an optical photograph demonstrating the layer quality of coatings prepared with the formulation of inventive example E-2. On the right side of each sample is a ruler with a mm scale.
Figure 6 demonstrates the layer thickness in nm vs. the inverse spin speed in 1/rpm. The formulation based on comparative example CE-4 is represented by crosses and a solid line. The formulation based on the inventive example E-1 is represented by dots and a dotted line.

### Examples

### General considerations

All experimental work is conducted in glove boxes manufactured by MBraun Inertgas-Systeme GmbH or via standard Schlenk technique (D. F. Shriver, M. A. Drezdzon, The manipulation of air sensitive compounds, 1986, Wiley VCH, New York, USA) under an inert atmosphere of dry nitrogen (N₂; O₂-level: < 10 ppm; H₂O level: <10 ppm). Moreover, all experiments are carried out with dry and oxygen-free solvents. Dry, oxygen-free solvents (cyclooctane, toluene) are prepared via a solvent purification system of type MB-SPS-800-Auto manufactured by MBraun Inertgas-Systeme GmbH.

### Test methods

### Gel permeation chromatography (GPC)

GPC measurements are performed with an Agilent LC 1100 series system equipped with a PSS SDV linear S column. Cyclooctane is used as eluent and polybutadiene as reference.

### GC/MS measurement

Mass spectra are measured on a HP 5971/A/5890-II GC/MS coupling (HP 1 capillary column, length 25 m, diameter 0.2 mm, 0.33 µm poly(dimethylsiloxane)).

### Spin coating

Spin coating is performed on a G3P-8 spin coater manufactured by SCS Specialty Coating Systems, Inc.

### Preparation of wet films

The respective formulation is applied with a 1 mL syringe through a syringe filter (polytetrafluorethylene (PTFE)) with a 1 µm pore width onto a respective substrate. Wet films are generated by spin coating at 25 °C at certain revolutions per minute (rpm) for a certain time.

### Ellipsometry measurement

Ellipsometry measurements are performed with a SENpro ellipsometer manufactured by SENTECH Gesellschaft für Sensortechnik mbH with fixed incidence angles between 40 and 90° (5° steps).

### Density measurement

Density measurements are performed with a DMA 500 manufactured by Anton Paar GmbH.

### Surface tension measurements

Surface tension measurements are performed with a Pocket Dyne bubble pressure tensiometer manufactured by Krüss GmbH.

### Kinematic viscosity measurement

Kinematic viscosity measurements are performed manually by means of micro-Ostwald viscometers of type 516 manufactured by SI Analytics GmbH.

### Characterization of hydridosilane composition

The hydridosilane composition 1 used in the following examples is provided from a commercial SiH₄-based fluidized bed reactor (FBR) process for polysilicon production.

The hydridosilane composition 1 is a liquid, colorless oil. A density of 0.95 g/mL, a dynamic viscosity of 8.3 mPas and a surface tension of 29.3 mN/m are determined by the methods as described above. The hydridosilane composition 1 has a mass average molecular weight of M_{w} = 1058 g/mol, a number average molecular weight of Mn = 568 g/mol and a polydispersity of D = 1.86 determined by GPC measurement as described above.

The hydridosilane composition 1 is composed of silane (1.2 %), disilane (4.0 %), trisilane (5.2 %), tetrasilane isomers (4.0 %), n-pentasilane (2.7 %), iso-pentasilane (4.9 %), hexasilane isomers (15.9 %), heptasilane isomers (10.2 %), octasilane isomers (9.3 %), nonasilane isomers (13.5 %) and higher silanes (SiₙH₂ₙ₊₂ with n > 9; 29.2 %) determined by GC/MS as described above.

### Comparative example 1 (CE-1)

The hydridosilane composition 1 is diluted in a ratio of 1:2 with a toluene mixture containing 10 % of cyclooctane. The formulation is prepared at ambient temperature (20 °C) and applied with a syringe through a syringe filter (PTFE) with a 1 µm pore width onto a pre-cleaned EagleXG glass substrate (Corning Inc.). Pre-cleaning is carried out by putting the substrates into acetone, isopropanol and subsequently deionized water in an ultrasonic bath for 10 minutes each. Before coating, substrates are dried completely in a nitrogen flow. Wet films are generated by spin coating at 25 °C at 4500, 9000 and 9999 rpm for 10 sec. Conversion of the wet films is conducted by thermal treatment on a hot plate at 500 °C for 60 sec.

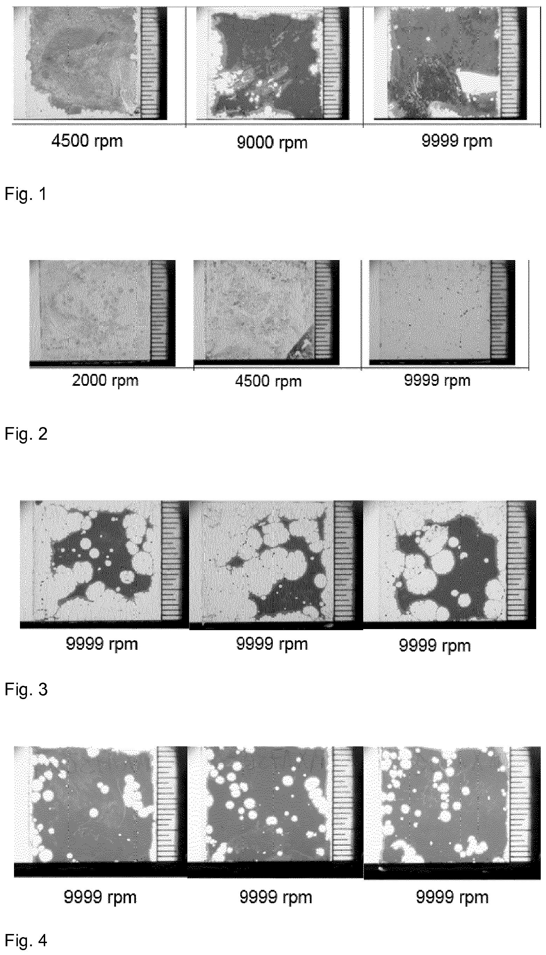

Photographs of the respective silicon-containing layer are shown in Figure 1. Dark grey areas represent coated substrate surface by amorphous silicon. Light grey/white areas result from dewetted substrate surface. It is evident that a conformal and continuous layer is not obtained.

### Comparative example 2 (CE-2)

The hydridosilane composition 1 is applied neat with a syringe through a syringe filter (PTFE) with a 1 µm pore width onto a pre-cleaned EagleXG glass substrate (Corning Inc.). Pre-cleaning is carried out by putting the substrates into acetone, isopropanol and subsequently deionized water in an ultrasonic bath for 10 minutes each. Before coating, substrates are dried completely in a nitrogen flow. Wet films are generated by spin coating at 25 °C at 2000, 4500 and 9999 rpm for 10 sec. Conversion of the wet films is conducted by thermal treatment on a hot plate at 500 °C for 60 sec.

Photographs of the respective silicon-containing layer are shown in Figure 2. Dark grey areas represent coated substrate surface by amorphous silicon. Light grey/white areas result from dewetted substrate surface. All films show almost complete dewetting. It is evident that a conformal and continuous layer is not obtained.

### Comparative example 3 (CE-3)

The hydridosilane composition 1 is put into a glass apparatus equipped with a reflux condenser. The hydridosilane composition 1 is oligomerized by heating to 100 °C for two hours while stirring and illuminating with a cold light lamp, which is connected to the reactor via fiber optics purchased from Micro-Epsilon Eltrotec GmbH. During the oligomerization reaction, the gas volume above the liquid reactant is purged with inert gas. The oligomerization reaction is monitored by means of GPC and the mass average molecular weight of the final hydridosilane oligomer 1 is M_{w} = 1761 g/mol.

The hydridosilane oligomer 1 is diluted in a ratio of 1:2 with a toluene mixture containing 10 % of cyclooctane. The formulation is prepared at ambient temperature (20 °C) and applied with a syringe through a syringe filter (PTFE) with a 1 µm pore width onto a pre-cleaned EagleXG glass substrate (Corning Inc.). Pre-cleaning is carried out by putting the substrates into acetone, isopropanol and subsequently deionized water in an ultrasonic bath for 10 minutes each. Before coating, substrates are dried completely in a nitrogen flow. Three wet films are generated by spin coating at 25 °C at 9999 rpm for 10 sec each. Conversion of the wet films is conducted by thermal treatment on a hot plate at 500 °C for 60 sec.

Photographs of the respective silicon-containing layer are shown in Figure 3. Dark grey areas represent coated substrate surface by amorphous silicon. Light grey/white areas result from dewetted substrate surface. All films show significant dewetting. It is evident that a conformal and continuous layer is not obtained.

### Example 1 (E-1)

A high molecular weight neopentasilane oligomer (4 wt.-%) having a mass average molecular weight of M_{w} = 2531 g/mol is added to the hydridosilane composition 1 (96 wt.-%). The resulting reaction mixture is put into a glass apparatus equipped with a reflux condenser. The reaction mixture is oligomerized by heating to 100 °C for two hours while stirring and illuminating with a cold light lamp, which is connected to the reactor via fiber optics purchased from Micro-Epsilon Eltrotec GmbH. During the oligomerization reaction, the gas volume above the liquid reactant is purged with inert gas. The oligomerization reaction is monitored by means of GPC and the mass average molecular weight of the final hydridosilane oligomer 2 is M_{w} = 1742 g/mol.

The hydridosilane oligomer 2 is diluted in a ratio of 1:2 with a toluene mixture containing 10 % of cyclooctane. The formulation is prepared at ambient temperature (20 °C) and applied with a syringe through a syringe filter (PTFE) with a 1 µm pore width onto a pre-cleaned EagleXG glass substrate (Corning Inc.). Pre-cleaning is carried out by putting the substrates into acetone, isopropanol and subsequently deionized water in an ultrasonic bath for 10 minutes each. Before coating, substrates are dried completely in a nitrogen flow. Three wet films are generated by spin coating at 25 °C at 9999 rpm for 10 sec each. Conversion of the wet films is conducted by thermal treatment on a hot plate at 500 °C for 60 sec.

Photographs of the respective silicon-containing layer are shown in Figure 4. Dark grey areas represent coated substrate surface by amorphous silicon. Light grey/white areas result from dewetted substrate surface. All films show reduced dewetting. A conformal and continuous amorphous silicon film is obtained on more than 50% of the substrate surface.

### Example 2 (E-2)

A high molecular weight neopentasilane oligomer (4 wt.-%) having a mass average molecular weight of M_{w} = 2531 g/mol is added to a mixture of neopentasilane (46 wt.-%) and the hydridosilane composition 1 (50 wt.-%). The resulting reaction mixture is put into a glass apparatus equipped with a reflux condenser. The reaction mixture is oligomerized by heating to 100 °C for two hours while stirring and illuminating with a cold light lamp, which is connected to the reactor via fiber optics purchased from Micro-Epsilon Eltrotec GmbH. During the oligomerization reaction, the gas volume above the liquid reactant is purged with inert gas. The oligomerization reaction is monitored by means of GPC and the mass average molecular weight of the final hydridosilane oligomer 3 is M_{w} = 1732 g/mol.

The hydridosilane oligomer 3 is diluted in a ratio of 1:2 with a toluene mixture containing 10 % of cyclooctane. The formulation is prepared at ambient temperature (20 °C) and applied with a syringe through a syringe filter (PTFE) with a 1 µm pore width onto a pre-cleaned EagleXG glass substrate (Corning Inc.). Pre-cleaning is carried out by putting the substrates into acetone, isopropanol and subsequently deionized water in an ultrasonic bath for 10 minutes each. Before coating, substrates are dried completely in a nitrogen flow. Wet films are generated by spin coating at 25 °C at 2000, 4500 and 9999 rpm for 10 sec. Conversion of the wet films is conducted by thermal treatment on a hot plate at 500 °C for 60 sec.

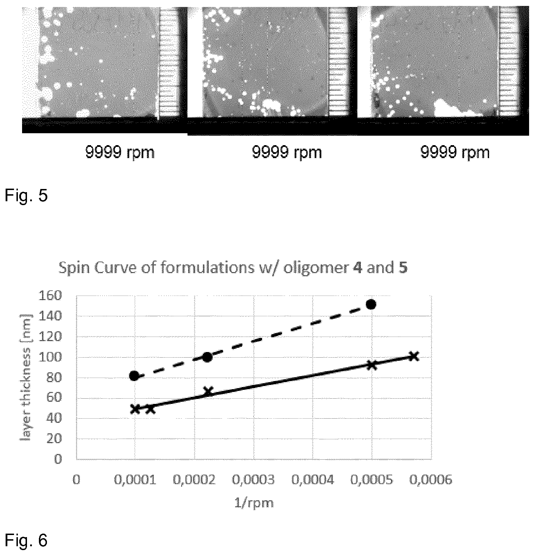

Photographs of the respective silicon-containing layer are shown in Figure 5. Dark grey areas represent coated substrate surface by amorphous silicon. Light grey/white areas result from dewetted substrate surface. For all films, the dewetting is reduced further compared to E-1. A conformal and continuous amorphous silicon film is obtained on more than 80% of the substrate surface.

### Comparative example 4 (CE-4)

Neopentasilane is put into a glass apparatus equipped with a reflux condenser. The neopentasilane is oligomerized by heating to 140 °C for two hours while stirring and illuminating with a cold light lamp, which is connected to the reactor via fiber optics purchased from Micro-Epsilon Eltrotec GmbH. During the oligomerization reaction, the gas volume above the liquid reactant is purged with inert gas. The oligomerization reaction is monitored by means of GPC and the mass average molecular weight of the final hydridosilane oligomer 4 is M_{w} = 1751 g/mol.

The hydridosilane oligomer 4 is diluted in a ratio of 1:2 with a toluene mixture containing 10 % of cyclooctane. The formulation is prepared at ambient temperature (20 °C) and applied with a syringe through a syringe filter (PTFE) with a 1 µm pore width onto a pre-cleaned EagleXG glass substrate (Corning Inc.). Pre-cleaning is carried out by putting the substrates into acetone, isopropanol and subsequently deionized water in an ultrasonic bath for 10 minutes each. Before coating, substrates are dried completely in a nitrogen flow.

Wet films are generated by spin coating at 25 °C at 1750, 2000, 4500, 8000 and 9999 rpm for 10 sec. Conversion of the wet films is conducted by thermal treatment on a hot plate at 500 °C for 60 sec.

### Determination of layer thickness

The layer thicknesses of the silicon-containing layers of E-2 and CE-4 are determined by means of spectral ellipsometry as described above and are shown in Figure 6. It is evident, that formulations based on the hydridosilane oligomer 3 give significant higher layer thicknesses of the corresponding amorphous silicon layers than the formulations based on hydridosilane oligomer 4 featuring the same solid contents and solvent mixtures.

## Claims

1. A method for preparing hydridosilane oligomers, comprising:
reacting a hydridosilane composition (I) comprising at least one linear hydridosilane SiₙH₂ₙ₊₂ with n ≥ 2 in the presence of a branched hydridosilane compound (II),
wherein the branched hydridosilane compound (II) comprises at least one quaternary silicon atom Si(SiR₃)₄, wherein R is chosen from the group consisting of H; SiₙH₂ₙ₊₁ with n ≥ 1; SiₘH₂ₘ with m ≥ 2; and SiⱼH₂ⱼ₋₁ with j ≥ 3.

2. The method according to claim 1, wherein the branched hydridosilane compound (II) is present in a range of 0.05 to 50 wt.-%, based on the total weight of the hydridosilane composition (I) and the branched hydridosilane compound (II).

3. The method according to any one of the preceding claims, wherein the branched hydridosilane compound (II) is selected from the group consisting of neopentasilane, neopentasilane oligomer, 2,2-disilyltetrasilane, 2,2-disilylpentasilane, 3,3-disilylpentasilane, 2,2,3-trisilyltetrasilane, 1,1-disilylcyclopentasilane, 2,2,3,3-tetrasilyltetrasilane, 2,2,3-trisilylpentasilane, 2,2,4-trisilylpentasilane, 2,2-disilylhexasilane, 3,3-disilylhexasilane, 1,1-disilylcyclohexasilane, 1,1,2-trisilylcyclopentasilane, 1,1,3-trisilylcyclopentasilane, 2,2-disilylheptasilane, 3,3-disilylheptasilane, 4,4-disilylheptasilane, 2,2,3-trisilylheptasilane, 2,2,4-trisilylheptasilane, 2,2,5-trisilylheptasilane, 2,3,3-trisilylheptasilane, 3,3,4-trisilylheptasilane, 3,3,5-trisilylheptasilane, 3-disilaneyl-3-silylhexasilane, 2,2,3,3 tetrasilylpentasilane, 2,2,3,4-tetrasilylpentasilane, 2,2,4,4-tetrasilylpentasilane, 2,3,3,4-tetrasilylpentasilane, 3-disilaneyl-2,2-disilylpentasilane, 3,3-bis(disilaneyl)pentasilane, 1,1,2-trisilylcyclohexasilane, 1,1,3-trisilylcylohexasilane, 1,1,4-trisilylcyclohexasilane, 1,1,2,2-tetrasilylcyclohexasilane, 1,1,3,3-tetrasilylcyclohexasilane, 1,1,4,4-tetrasilylcyclohexasilane, 1,1,2,3-tetrasilylcyclohexasilane, 1,1,2,4-tetrasilylcyclohexasilane, 1,1,3,4-tetrasilylcyclohexasilane and mixtures thereof, preferably from the group consisting of neopentasilane, neopentasilane oligomer, and mixtures thereof.

4. The method according to any one of the preceding claims, wherein the hydridosilane composition (I) is reacted in the presence of the branched hydridosilane compound (II) in the absence of a catalyst and/or wherein the reaction is solvent free.

5. The method according to any one of the preceding claims, wherein the hydridosilane composition (I) comprises at least one linear hydridosilane SiₙH₂ₙ₊₂, wherein n is 2 to 9.

6. The method according to any one of the preceding claims, wherein the hydridosilane composition (I) is reacted in the presence of the branched hydridosilane compound (II) at a temperature in the range of 50 °C to 300 °C and by irradiating with electromagnetic radiation, preferably in the visible spectral range.

7. The method according to any one of the preceding claims, wherein the hydridosilane composition (I) comprises hydridosilane mixtures having a mass average molecular weight of M_{w} in the range of 200 to 5000 g/mol, preferably 1000 to 3000 g/mol, measured by gel permeation chromatography (GPC) and/or wherein the neopentasilane oligomer (II) has a mass average molecular weight of M_{w} in the range of 500 to 5000 g/mol, preferably 1500 to 3500 g/mol measured by gel permeation chromatography (GPC).

8. The method according to any one of the preceding claims, wherein the branched hydridosilane compound (II) consists of 80 to 98 wt.-% of neopentasilane and 2 to 20 wt.-% of a neopentasilane oligomer, preferably of 85 to 94 wt.-% of neopentasilane and 6 to 15 wt.-% of a neopentasilane oligomer, more preferably of 90 to 92 wt.-% of neopentasilane and 8 to 10 wt.-% of a neopentasilane oligomer, based on the total weight of the branched hydridosilane compound (II).

9. The method according to any one of the preceding claims, wherein at least one dopant selected from the group consisting of
BHₓR₃₋ₓ, wherein x = 0 - 3 and R = C₁-C₁₀-alkyl radical, unsaturated cyclic, optionally ether- or amino-complexed C₂-C₁₀-alkyl radical;
Si₅H₉BR₂, wherein R = H, Ph, or C₁-C₁₀-alkyl radical;
Si₄H₉BR₂, wherein R = H, Ph, or C₁-C₁₀-alkyl radical;
red phosphorous;
white phosphorous (P₄);
PHₓR₃₋ₓ, wherein x = 0 - 3 and R = Ph, SiMe₃, or C₁-C₁₀-alkyl radical;
P₇(SiR₃)₃, wherein R = H, Ph, or C₁-C₁₀-alkyl radical;
Si₅H₉PR₂, wherein R = H, Ph, or C₁-C₁₀-alkyl radical; and
Si₄H₉PR₂, wherein R = H, Ph, or C₁-C₁₀-alkyl radical
is added before, during or after the reaction.

10. A hydridosilane oligomer obtainable by the method according to any one of the preceding claims.

11. The hydridosilane oligomer according to claim 10, wherein the hydridosilane oligomer has a mass average molecular weight of M_{w} in the range of 500 to 5000 g/mol, measured by gel permeation chromatography (GPC).

12. A method for preparing a coating composition comprising:
(i) preparing hydridosilane oligomers according to the method according to any of claims 1 to 9; and
(ii) diluting the hydridosilane oligomers with an organic solvent, preferably with an organic solvent selected from the group consisting of toluene and cyclooctane.

13. The method according to claim 12, wherein the coating composition comprises 0.1 to 99 wt.-%, more preferably 10 to 97 wt.-%, most preferably 25 to 95 wt.-%, and in particular 60 to 80 wt.-% of the organic solvent, based on the total weight of the hydridosilane oligomer and the organic solvent.

14. A method for preparing a silicon-containing layer, comprising:
(a) preparing hydridosilane oligomers according to the method according to any of claims 1 to 9;
(b) optionally diluting the hydridosilane oligomers with an organic solvent, preferably with an organic solvent selected from the group consisting of toluene and cyclooctane;
(c) applying the hydridosilane oligomer formulation on a substrate; and
(d) converting the hydridosilane oligomer formulation into amorphous silicon.

15. The method according to claim 14, wherein the application step (c) is carried out by printing, spraying, aerosol assisted chemical vapor deposition, direct liquid injection chemical vapor deposition, spin-coating, dip-coating, meniscus coating, slit coating, slot-die coating and curtain coating; and/or
wherein the conversion step (d) is carried out thermally and/or by using electromagnetic radiation and/or by electron ion bombardment.

16. A use of hydridosilane oligomers obtained by the method according to any one of claims 1 to 9 for producing an optoelectronic or electronic component.

## Patentansprüche

1. Verfahren zur Herstellung von Hydridosilan-Oligomeren, umfassend:
Umsetzen einer Hydridosilan-Zusammensetzung (I), die mindestens ein lineares Hydridosilan SiₙH₂ₙ₊₂ mit n ≥ 2 umfasst, in Gegenwart einer verzweigten Hydridosilan-Verbindung (II),
wobei die verzweigte Hydridosilan-Verbindung (II) mindestens ein quartäres Siliciumatom Si(SiR₃)₄ umfasst, wobei R aus der Gruppe bestehend aus H, SiₙH₂ₙ₊₂ mit n ≥ 1, SiₘH₂ₘ mit m ≥ 2 und SiⱼH₂ⱼ₋₁ mit j ≥ 3 ausgewählt ist.

2. Verfahren nach Anspruch 1, wobei die verzweigte Hydridosilan-Verbindung (II) in einem Bereich von 0,05 bis 50 Gew.-%, bezogen auf das Gesamtgewicht der Hydridosilan-Zusammensetzung (I) und der verzweigten Hydridosilan-Verbindung (II), vorliegt.

3. Verfahren nach einem der vorhergehenden Ansprüche, wobei die verzweigte Hydridosilan-Verbindung (II) aus der Gruppe bestehend aus Neopentasilan, Neopentasilan-Oligomer, 2,2-Disilyltetrasilan, 2,2-Disilylpentasilan, 3,3-Disilylpentasilan, 2,2,3-Trisilyltetrasilan, 1,1-Disilylcyclopentasilan, 2,2,3,3-Tetrasilyltetrasilan, 2,2,3-Trisilylpentasilan, 2,2,4-Trisilylpentasilan, 2,2-Disilylhexasilan, 3,3-Disilylhexasilan, 1,1-Disilylcyclohexasilan, 1,1,2-Trisilylcyclopentasilan, 1,1,3-Trisilylcyclopentasilan, 2,2-Disilylheptasilan, 3,3-Disilylheptasilan, 4,4-Disilylheptasilan, 2,2,3-Trisilylheptasilan, 2,2,4-Trisilylheptasilan, 2,2,5-Trisilylheptasilan, 2,3,3-Trisilylheptasilan, 3,3,4-Trisilylheptasilan, 3,3,5-Trisilylheptasilan, 3-Disilanyl-3-silylhexasilan, 2,2,3,3-Tetrasilylpentasilan, 2,2,3,4-Tetrasilylpentasilan, 2,2,4,4-Tetrasilylpentasilan, 2,3,3,4-Tetrasilylpentasilan, 3-Disilanyl-2,2-disilylpentasilan, 3,3-Bis(di-silanyl)pentasilan, 1,1,2-Trisilylcyclohexasilan, 1,1,3-Trisilylcylohexasilan, 1,1,4-Trisilylcyclohexasilan, 1,1,2,2-Tetrasilylcyclohexasilan, 1,1,3,3-Tetrasilylcyclohexasilan, 1,1,4,4-Tetrasilylcyclohexasilan, 1,1,2,3-Tetrasilylcyclohexasilan, 1,1,2,4-Tetrasilylcyclohexasilan, 1,1,3,4-Tetrasilylcyclohexasilan und Mischungen davon, vorzugsweise aus der Gruppe bestehend aus Neopentasilan, Neopentasilan-Oligomer und Mischungen davon, ausgewählt wird.

4. Verfahren nach einem der vorhergehenden Ansprüche, wobei die Hydridosilan-Zusammensetzung (I) in Gegenwart der verzweigten Hydridosilan-Verbindung (II) in Abwesenheit eines Katalysators umgesetzt wird und/oder wobei die Umsetzung lösungsmittelfrei ist.

5. Verfahren nach einem der vorhergehenden Ansprüche, wobei die Hydridosilan-Zusammensetzung (I) mindestens ein lineares Hydridosilan SiₙH₂ₙ₊₂, worin n für 2 bis 9 steht, umfasst.

6. Verfahren nach einem der vorhergehenden Ansprüche, wobei die Hydridosilan-Zusammensetzung (I) in Gegenwart der verzweigten Hydridosilan-Verbindung (II) bei einer Temperatur im Bereich von 50 °C bis 300 °C und durch Bestrahlen mit elektromagnetischer Strahlung, vorzugsweise im sichtbaren Spektralbereich, umgesetzt wird.

7. Verfahren nach einem der vorhergehenden Ansprüche, wobei die Hydridosilan-Zusammensetzung (I) Hydridosilan-Gemische mit einem durch Gelpermeationschromatographie (GPC) gemessenen massenmittleren Molekulargewicht M_{w} im Bereich von 200 bis 5000 g/mol, vorzugsweise 1000 bis 3000 g/mol umfasst und/oder wobei das Neopentansilan-Oligomer (II) ein durch Gelpermeationschromatographie (GPC) gemessenes massenmittleres Molekulargewicht M_{w} im Bereich von 500 bis 5000 g/mol, vorzugsweise 1500 bis 3500 g/mol, aufweist.

8. Verfahren nach einem der vorhergehenden Ansprüche, wobei die verzweigte Hydridosilan-Verbindung (II) aus 80 bis 98 Gew.-% Neopentansilan und 2 bis 20 Gew.-% eines Neopentansilan-Oligomers, vorzugsweise 85 bis 94 Gew.-% Neopentansilan und 6 bis 15 Gew.-% eines Neopentansilan-Oligomers, weiter bevorzugt 90 bis 92 Gew.-% Neopentansilan und 8 bis 10 Gew.-% eines Neopentansilan-Oligomers, bezogen auf das Gesamtgewicht der verzweigten Hydridosilan-Verbindung (II), besteht.

9. Verfahren nach einem der vorhergehenden Ansprüche, wobei mindestens ein Dotierstoff aus der Gruppe bestehend aus
BHₓR₃₋ₓ, worin x = 0-3 und R = C₁-C₁₀-Alkylrest, ungesättigter cyclischer, gegebenenfalls ether- oder aminokomplexierter C₂-C₁₀-Alkylrest;
Si₅H₉BR₂, worin R = H, Ph oder C₁-C₁₀-Alkylrest; Si₄H₉BR₂, worin R = H, Ph oder C₁-C₁₀-Alkylrest; rotem Phosphor;
weißem Phosphor (P₄);
PHₓR₃₋ₓ, worin x = 0-3 und R = Ph, SiMe₃ oder C₁-C₁₀-Alkylrest;
P₇(SiR₃)₃, worin R = H, Ph oder C₁-C₁₀-Alkylrest;
Si₅H₉PR₂, worin R = H, Ph oder C₁-C₁₀-Alkylrest; und Si₄H₉PR₂, worin R = H, Ph oder C₁-C₁₀-Alkylrest;
vor, während oder nach der Umsetzung zugegeben wird.

10. Hydridosilan-Oligomer, das durch das Verfahren nach einem der vorhergehenden Ansprüche erhältlich ist.

11. Hydridosilan-Oligomer nach Anspruch 10, wobei das Hydridosilan-Oligomer ein durch Gelpermeationschromatographie (GPC) gemessenes massenmittleres Molekulargewicht M_{w} im Bereich von 500 bis 5000 g/mol aufweist.

12. Verfahren zur Herstellung einer Beschichtungszusammensetzung, umfassend:
(i) Herstellen von Hydridosilan-Oligomeren gemäß dem Verfahren nach einem der Ansprüche 1 bis 9 und
(ii) Verdünnen der Hydridosilan-Oligomere mit einem organischen Lösungsmittel, vorzugsweise mit einem organischen Lösungsmittel aus der Gruppe bestehend aus Toluol und Cyclooctan.

13. Verfahren nach Anspruch 12, wobei die Beschichtungszusammensetzung 0,1 bis 99 Gew.-%, weiter bevorzugt 10 bis 97 Gew.-%, ganz besonders bevorzugt 25 bis 95 Gew.-% und insbesondere 60 bis 80 Gew.-% des organischen Lösungsmittels, bezogen auf das Gesamtgewicht des Hydridosilan-Oligomers und des organischen Lösungsmittels, umfasst.

14. Verfahren zur Herstellung einer siliciumhaltigen Schicht, umfassend:
(a) Herstellen von Hydridosilan-Oligomeren gemäß dem Verfahren nach einem der Ansprüche 1 bis 9;
(b) gegebenenfalls Verdünnen der Hydridosilan-Oligomere mit einem organischen Lösungsmittel, vorzugsweise mit einem organischen Lösungsmittel aus der Gruppe bestehend aus Toluol und Cyclooctan;
(c) Aufbringen der Hydridosilan-Oligomer-Formulierung auf ein Substrat und
(d) Umwandeln der Hydridosilan-Oligomer-Formulierung in amorphes Silicium.

15. Verfahren nach Anspruch 14, wobei der Aufbringungsschritt (c) durch Drucken, Sprühen, Aerosol Assisted Chemical Vapor Deposition, Direct Liquid Injection Chemical Vapor Deposition, Aufschleudern, Tauchbeschichten, Meniskusbeschichten, Schlitzbeschichten, Schlitzdüsenbeschichten und Vorhangbeschichten durchgeführt wird und/oder
wobei der Umwandlungsschritt (d) thermisch und/oder durch Verwendung von elektromagnetischer Strahlung und/oder durch Elektronenionenbeschuss durchgeführt wird.

16. Verwendung von durch das Verfahren nach einem der Ansprüche 1 bis 9 erhaltenen Hydridosilan-Oligomeren zur Herstellung eines optoelektronischen oder elektronischen Bauteils.

## Revendications

1. Procédé pour la préparation d'oligomères d'hydridosilane, comprenant :
la mise en réaction d'une composition (I) d'hydridosilane comprenant au moins un hydridosilane linéaire SiₙH₂ₙ₊₂ avec n ≥ 2 en la présence d'un composé (II) de type hydridosilane ramifié,
le composé (II) de type hydridosilane ramifié comprenant au moins un atome de silicium quaternaire Si(SiR₃)₄, R étant choisi dans le groupe constitué par H ; SiₙH₂ₙ₊₁ avec n ≥ 1 ; SiₘH₂ₘ avec m ≥ 2 ; et SiⱼH₂ⱼ₋₁ avec j ≥ 3.

2. Procédé selon la revendication 1, le composé (II) de type hydridosilane ramifié étant présent dans une plage de 0,05 à 50 % en poids, sur la base du poids total de la composition (I) d'hydridosilane et du composé (II) de type hydridosilane ramifié.

3. Procédé selon l'une quelconque des revendications précédentes, le composé (II) de type hydridosilane ramifié étant choisi dans le groupe constitué par le néopentasilane, un oligomère de néopentasilane, le 2,2-disilyltétrasilane, le 2,2-disilylpentasilane, le 3,3-disilylpentasilane, le 2,2,3-trisilyltétrasilane, le 1,1-disilylcyclopentasilane, le 2,2,3,3-tétrasilyltétrasilane, le 2,2,3-trisilylpentasilane, le 2,2,4-trisilylpentasilane, le 2,2-disilylhexasilane, le 3,3-disilylhexasilane, le 1,1-disilylcyclohexasilane, le 1,1,2-trisilylcyclopentasilane, le 1,1,3-trisilylcyclopentasilane, le 2,2-disilylheptasilane, le 3,3-disilylheptasilane, le 4,4-disilylheptasilane, le 2,2,3-trisilylheptasilane, le 2,2,4-trisilylheptasilane, le 2,2,5-trisilylheptasilane, le 2,3,3-trisilylheptasilane, le 3,3,4-trisilylheptasilane, le 3,3,5-trisilylheptasilane, le 3-disilanéyl-3-silylhexasilane, le 2,2,3,3-tétrasilylpentasilane, le 2,2,3,4-tétrasilylpentasilane, le 2,2,4,4-tétrasilylpentasilane, le 2,3,3,4-tétrasilylpentasilane, le 3-disilanéyl-2,2-disilylpentasilane, le 3,3-bis(disilanéyl)pentasilane, le 1,1,2-trisilylcyclohexasilane, le 1,1,3-trisilylcylohexasilane, le 1,1,4-trisilylcyclohexasilane, le 1,1,2,2-tétrasilylcyclohexasilane, le 1,1,3,3-tétrasilylcyclohexasilane, le 1,1,4,4-tétrasilylcyclohexasilane, le 1,1,2,3-tétrasilylcyclohexasilane, le 1,1,2,4-tétrasilylcyclohexasilane, le 1,1,3,4-tétrasilylcyclohexasilane et des mélanges correspondants, préférablement dans le groupe constitué par néopentasilane, un oligomère de néopentasilane, et des mélanges correspondants.

4. Procédé selon l'une quelconque des revendications précédentes, la composition (I) d'hydridosilane étant mise à réagir en la présence du composé (II) de type hydridosilane ramifié en l'absence d'un catalyseur et/ou la réaction étant exempte de solvant.

5. Procédé selon l'une quelconque des revendications précédentes, la composition (I) d'hydridosilane comprenant au moins un hydridosilane linéaire SiₙH₂ₙ₊₂, n étant 2 à 9.

6. Procédé selon l'une quelconque des revendications précédentes, la composition (I) d'hydridosilane étant mise à réagir en la présence du composé (II) de type hydridosilane ramifié à une température dans la plage de 50 °C à 300 °C et par irradiation avec un rayonnement électromagnétique, préférablement dans le domaine spectral du visible.

7. Procédé selon l'une quelconque des revendications précédentes, la composition (I) d'hydridosilane comprenant des mélanges d'hydridosilanes possédant un poids moléculaire moyen en masse M_{w} dans la plage de 200 à 5 000 g/mole, préférablement 1 000 à 3 000 g/mole, mesuré par chromatographie à perméation de gel (CPG) et/ou l'oligomère (II) de néopentasilane possédant un poids moléculaire moyen en masse M_{w} dans la plage de 500 à 5 000 g/mole, préférablement 1 500 à 3 500 g/mole, mesuré par chromatographie à perméation de gel (CPG).

8. Procédé selon l'une quelconque des revendications précédentes, le composé (II) de type hydridosilane ramifié étant constitué de 80 à 98 % en poids de néopentasilane et 2 à 20 % en poids d'un oligomère de néopentasilane, préférablement de 85 à 94 % en poids de néopentasilane et 6 à 15 % en poids d'un oligomère de néopentasilane, plus préférablement de 90 à 92 % en poids de néopentasilane et 8 à 10 % en poids d'un oligomère de néopentasilane, sur la base du poids total du composé (II) de type hydridosilane ramifié.

9. Procédé selon l'une quelconque des revendications précédentes, au moins un dopant choisi dans le groupe constitué par
BHₓR₃₋ₓ, x = 0 à 3 et R = radical C₁-C₁₀-alkyle, radical C₂-C₁₀-alkyle cyclique insaturé, éventuellement complexé par un éther ou un amino ;
Si₅H₉BR₂, R = H, Ph, ou radical C₁-C₁₀-alkyle ;
Si₄H₉BR₂, R = H, Ph, ou radical C₁-C₁₀-alkyle ;
le phosphore rouge ;
le phosphore blanc (P₄) ;
PHₓR₃₋ₓ, x = 0 à 3 et R = Ph, SiMe₃, ou radical C₁-C₁₀-alkyle ;
P₇(SiR₃)₃, R = H, Ph, ou radical C₁-C₁₀-alkyle ;
Si₅H₉PR₂, R = H, Ph, ou radical C₁-C₁₀-alkyle ; et Si₄H₉PR₂, R = H, Ph, ou radical C₁-C₁₀-alkyle étant ajouté avant, pendant ou après la réaction.

10. Oligomère d'hydridosilane pouvant être obtenu par le procédé selon l'une quelconque des revendications précédentes.

11. Oligomère d'hydridosilane selon la revendication 10, l'oligomère d'hydridosilane possédant un poids moléculaire moyen en masse M_{w} dans la plage de 500 à 5 000 g/mole, mesuré par chromatographie à perméation de gel (CPG).

12. Procédé pour la préparation d'une composition de revêtement comprenant :
(i) la préparation d'oligomères d'hydridosilane selon le procédé selon l'une quelconque des revendications 1 à 9 ; et
(ii) la dilution des oligomères d'hydridosilane avec un solvant organique, préférablement avec un solvant organique choisi dans le groupe constitué par le toluène et le cyclooctane.

13. Procédé selon la revendication 12, la composition de revêtement comprenant 0,1 à 99 % en poids, plus préférablement 10 à 97 % en poids, le plus préférablement 25 à 95 % en poids, et en particulier 60 à 80 % en poids du solvant organique, sur la base du poids total de l'oligomère d'hydridosilane et du solvant organique.

14. Procédé pour la préparation d'une couche contenant du silicium, comprenant :
(a) la préparation d'oligomères d'hydridosilane selon le procédé selon l'une quelconque des revendications 1 à 9 ;
(b) éventuellement la dilution des oligomères d'hydridosilane avec un solvant organique, préférablement avec un solvant organique choisi dans le groupe constitué par le toluène et le cyclooctane ;
(c) l'application de la formulation d'oligomère d'hydridosilane sur un substrat ; et
(d) la conversion de la formulation d'oligomère d'hydridosilane en silicium amorphe.

15. Procédé selon la revendication 14, l'étape d'application (c) étant mise en œuvre par impression, par pulvérisation, par dépôt chimique en phase vapeur assisté par un aérosol, par dépôt chimique en phase vapeur par injection de liquide directe, par revêtement par centrifugation, par revêtement par trempage, par revêtement par ménisque, par revêtement à fente, par revêtement par filière plate et par revêtement au rideau ;
et/ou
l'étape de conversion (d) étant mise en œuvre thermiquement et/ou en utilisant un rayonnement électromagnétique et/ou par bombardement d'ions d'électrons.

16. Utilisation d'oligomères d'hydridosilane obtenus par le procédé selon l'une quelconque des revendications 1 à 9 pour la production d'un composant optoélectronique ou électronique.
